# EUROPEAN PATENT APPLICATION

(11) **EP 2 975 638 A1**
(43) Date of publication of application: **20.01.2016**
(21) Application number: 14177084.2
(22) Date of filing: 15.07.2014
(51) Int. Cl.: H01L 21/673, B28D 5/00, H01L 21/677

(54) **Processing apparatus for processing a semiconductor ingot, carrier and method of transferring and processing a semiconductor ingot**

(71) Applicant: Applied Materials Switzerland Sàrl, 1033 Cheseaux-sur-Lausanne (CH)
(72) Inventor: Straube, Ralph, 1110 Morges (CH)
(74) Representative: Zimmermann & Partner Patentanwälte mbB

(57) **Abstract**

A carrier for a semiconductor ingot is configured for top-loading and side-loading of a semiconductor ingot. The carrier includes a holder which attaches to the semiconductor ingot and can be placed at the top of a container. A side member is movable between an open position for side-loading and a closed position. A processing apparatus may move the side member of the carrier between the open and closed positions, and is configured to load and unload the semiconductor ingot from the carrier by side-loading and side-unloading.

## Description

### FIELD OF THE DISCLOSURE

Embodiments disclosed herein relate to a carrier for a semiconductor ingot used for transporting a semiconductor ingot in a solar cell manufacturing process. A method of transferring a semiconductor ingot, and a processing apparatus such as a wire saw are also disclosed.

### BACKGROUND OF THE DISCLOSURE

Solar cells are commonly formed on semiconductor substrates such as silicon. The manufacturing process often involves transporting semiconductor ingots between apparatus at various stages of processing, including wire saws for slicing of semiconductor ingots. Ingots of semiconductor materials can be processed, such as cut by a wire saw.

It is desirable, in the manufacture solar cells, to have rapid throughput of semiconductor materials with little waste, such as waste associated with breakage. There is therefore a need to improve the efficiency of loading and unloading of semiconductor ingots into and out of processing apparatuses and devices, including containers.

### SUMMARY OF THE DISCLOSURE

According to an aspect, a carrier for a semiconductor ingot is disclosed, which includes a container. The container includes a side member which is movable between an open position for side-loading and a closed position.

According to an aspect, a processing apparatus for processing a semiconductor ingot is also disclosed. The processing apparatus is configured to receive the semiconductor ingot, by side-unloading, from the carrier. The processing apparatus can be a wire saw.

According to an aspect, a method of transferring a semiconductor ingot to a processing apparatus is also disclosed, which includes: delivering a carrier which contains a semiconductor ingot to the processing apparatus; opening a side member of the carrier; and unloading the semiconductor ingot from the side of the carrier.

Further aspects, embodiments, details and examples are evident from the dependent claims, the following description and the accompanying drawings.

### BRIEF DESCRIPTION OF THE DRAWINGS

The accompanying drawings relate to embodiments described herein.
Figure 1 illustrates a carrier according to embodiments described herein.
Figure 2 illustrates a carrier cross-sectional side view according to embodiments described herein.
Figure 3 illustrates a carrier cross-sectional side view according to embodiments described herein.
Figure 4 illustrates a carrier cross-sectional side view according to embodiments described herein.
Figure 5 illustrates a carrier according to embodiments described herein.
Figure 6 illustrates a holder according to embodiments described herein.
Figure 7 illustrates a holder according to embodiments described herein.
Figure 8 illustrates a carrier according to embodiments described herein.
Figure 9 illustrates part of a carrier according to embodiments described herein.
Figure 10 illustrates part of a carrier according to embodiments described herein.
Figure 11 illustrates a carrier according to embodiments described herein.
Figures 12 through 16 illustrate unloading a semiconductor ingot from a carrier according to embodiments described herein.
Figures 17 through 24 illustrate loading a processed semiconductor ingot into a carrier according to embodiments described herein.
Figure 25 illustrates schematically a method of transferring a semiconductor ingot to a processing apparatus, according to embodiments described herein.
Figure 26 illustrates schematically a method of transferring and processing a semiconductor ingot, according to embodiments described herein.

### DETAILED DESCRIPTION

Herein, an "ingot" can be a semiconductor ingot such as silicon, particularly crystalline silicon, and/or a material for use as a solar cell. For example, an ingot can be a squared mono-crystalline silicon ingot, a multi-crystalline silicon brick, or a cylindrical semiconductor ingot. Herein, a semiconductor ingot can be, for example, a processed semiconductor ingot or semiconductor ingot prepared for processing such as further processing. Herein, a processed semiconductor ingot can be, for example, a sliced and/or cut semiconductor ingot.

Herein "loading" and "un-loading" of a semiconductor ingot can refer to the transfer of a semiconductor ingot into and out of, respectively, an apparatus and/or device, such as a carrier. Loading of a carrier may coincide with unloading of a semiconductor processing apparatus, and unloading of the carrier may coincide with the loading of a semiconductor processing apparatus.

Herein, "side-loading" of a semiconductor ingot can refer to the transfer of a semiconductor ingot in a horizontal direction into a device, such as into a carrier. "Side-unloading" can be the reverse process, such as transfer out of a device, a carrier for example, by movement in a substantially or totally horizontal direction. "Top-loading" (and "top-unloading") can refer, respectively, to the transfer of a semiconductor ingot in a substantially or totally vertical direction into (out of) a device, such as a carrier.

Herein, a "gripper" can be an "end effector," for example. A gripper can include a mechanism for grasping a holder, such as a holder of a semiconductor ingot.

Herein, an "actuator" can be a device which moves and can be adapted to move components such as a carrier, a movable member thereof, such as a door of a carrier, a door such as a door of a processing apparatus, such as a door to a chamber of a processing apparatus, such as the door of a wire saw, as well as combinations thereof. Herein, "access door" may refer to a door of a processing apparatus, such as a door of a chamber thereof.

Herein a "wire saw" can be a wire saw as used for cutting semiconductor materials, particularly photovoltaic semiconductor materials; a wire saw may cut ingots into bricks, wafers, and the like.

Herein, the "short axis" of a carrier, including the short axes of components (e.g. a holder, a container) thereof, can be perpendicular to a long axis of the carrier and/or component thereof. Herein, "top-loading" and "top loading" are used interchangeably and can be the reverse of "top unloading" and "top-unloading," and can coincide with motion, such as that of a carrier and/or semiconductor ingot, in a vertical direction. Herein, "side-loading" and "side loading" are used interchangeably and can be the reverse of "side-unloading" and "side unloading" and can coincide with motion, such as that of a carrier and/or semiconductor ingot, in a horizontal direction.

Herein, a "container" can be a structure for holding an item such as a semiconductor ingot. A "container" can define an internal space, such as an enclosed internal space. A container can have a complementary removable portion, such as a lid and/or holder which may also attach to the item, particularly a semiconductor ingot. A "holder" may be a lid in that it rests on the container, or remainder thereof, and may be regarded as part of the container.

Herein, an "open position" of the container can be such that an item (e.g. a semiconductor ingot) in the container is removable, particularly removable along a direction, such as along a horizontal direction, when the container is in the "open position," which may be in contrast to a "closed position" of the container. An open position may also be such that an item (e.g. a semiconductor ingot) can be placed into the container, such as placed into the container, such as along a particular direction. The container may have an open position and/or closed position; it is also contemplated that a component of the container, particularly a "side member" may have an open position and/or closed position.

Herein, a "side member" of a container can be a structure located along a side of a container, for example a bar, wall, and/or tube. A side member can have an "open position" which may be such that the side member is removed from the rest of the container. An alternative is that the side member can remain attached whether in either configuration, open or closed.

Reference will now be made in detail to various embodiments, one or more examples of which are illustrated in the figures. Within the following description of the drawings, the same reference numbers refer to the same components. Generally, only the differences with respect to individual embodiments are described. Each example is provided by way of explanation and is not necessarily meant as a limitation. For example, features illustrated or described as part of one embodiment can be used on or in conjunction with other embodiments to yield yet a further embodiment. The present disclosure is intended to include such modifications and variations.

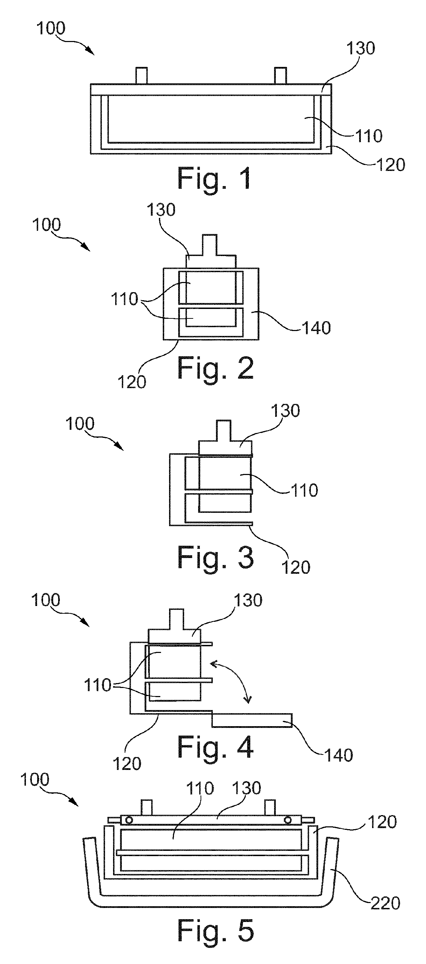

Fig. 1 illustrates a cross-sectional view of a carrier 100 according to embodiments described herein, which may be combined with any other embodiments described herein. Fig. 1 illustrates a loaded configuration of the carrier 100, in which a semiconductor ingot 110 is contained in the carrier 100. The container 120 of the carrier 100 includes a side member 140 which is movable between an open position for side-loading, such as a side-loading of a semiconductor ingot 110, and a closed position. The carrier 100 can include a container 120 and a holder 130 which can be reversibly placed at the top of the container 120. The holder can attach to the semiconductor ingot 110, which can be placed within the container with the holder 130 on top. The bottom of the holder 130 can attach to the semiconductor ingot 110. For example, the semiconductor ingot is attached to the bottom of the holder 130, and the container 120 contains the semiconductor ingot, with the holder 130 placed at the top of the container 120. The holder 130 can rest on the container 120 when the semiconductor ingot 110 is within the container. The container 120 can be configured for top-loading and side loading of a semiconductor ingot 110 attached to the holder 130. The holder 130 can be reversibly placed at the top of the container 120.

Fig. 2 illustrates a carrier 100 according to embodiments described herein, which may be combined with any other embodiments described herein. The container 120 can include a side member 140 which can be movable between a closed position, such as that depicted in Fig. 2, and an open position, such as that depicted in Figs. 3 and 4. Top-loading and top-unloading of the semiconductor ingot 110 can possible, for example with the embodiments of Figs. 1 and 2. The holder 130 can rest on the container 120 when the semiconductor ingot 110 is within the container 120. The holder 130 can be lifted vertically from the container 120. The side member 140, depicted in a closed position in Fig. 2, can be movable between the closed position and an open position for side-loading (and side unloading). The side member 140 can, for example, have an open position such that the side member 140 is above the top of the holder 130 and/or the remainder of the container 120. The side member 140 can be a side wall of the container 120, for example.

According to an embodiment which can be combined with any other embodiment disclosed herein, the side member 140 can be disposed parallel to the long axis of the carrier 100 when the side member 140 is in the closed position; optionally, the side member 140 is disposed parallel to the long axis of the carrier 100 when the side member is in the open position. The side-loading (and side-unloading) of the semiconductor ingot from the carrier can occur along the short axis. Accordingly, the travel distance of the semiconductor ingot 110 into/out of the carrier 100 can be reduced. Side loading and unloading along the short axis can be advantageous in that the tolerances are relaxed for maintaining a safe gap distance between the semiconductor ingot and the container. Maintaining a gap between the semiconductor ingot and the container, particularly during loading and unloading is preferable, because contact to the semiconductor ingot can result in damage.

Fig. 3 illustrates a cross-section of the carrier 100 in a configuration with the side member 140 moved to an open position for side-loading (and unloading), according to embodiments described herein, which may be combined with any other embodiments described herein. For example, the side member 140 can be lifted vertically, such as lifted such that a horizontal path is cleared for moving the semiconductor ingot 110 and holder 130 horizontally into and out of the container 120. The side member 140 can be configured to be moved by an actuator, particularly an actuator which is external to the carrier.

Fig. 4 illustrates a cross-section of the carrier 100 in a configuration with the side member 140 moved to an open position for side-loading (and unloading), according to embodiments described herein, which may be combined with any other embodiments described herein. The side member 140 can be rotatable. For example, a rotation of the side member 140 moves the side member 140 between the open position and the closed position. The rotation can be along an axis parallel to the long axis of the container 120.

It is also contemplated that the side member 140 is movable in a vertical direction. For example, the open position is such that the side member 140 is lifted above the holder 130, the holder 130 resting on the container 120. The closed position can be such that the side member 140 is disposed on a side of an internal space contained by the container 120, the internal space suitable for containing the semiconductor ingot 110.

Fig. 5 illustrates a cross-section of the carrier 100, according to embodiments described herein, which may be combined with any other embodiments described herein. Particularly in the case that the container 120 is not watertight, the carrier 100 can include a drip tray 220 and/or be operated in combination with a drip tray 220.

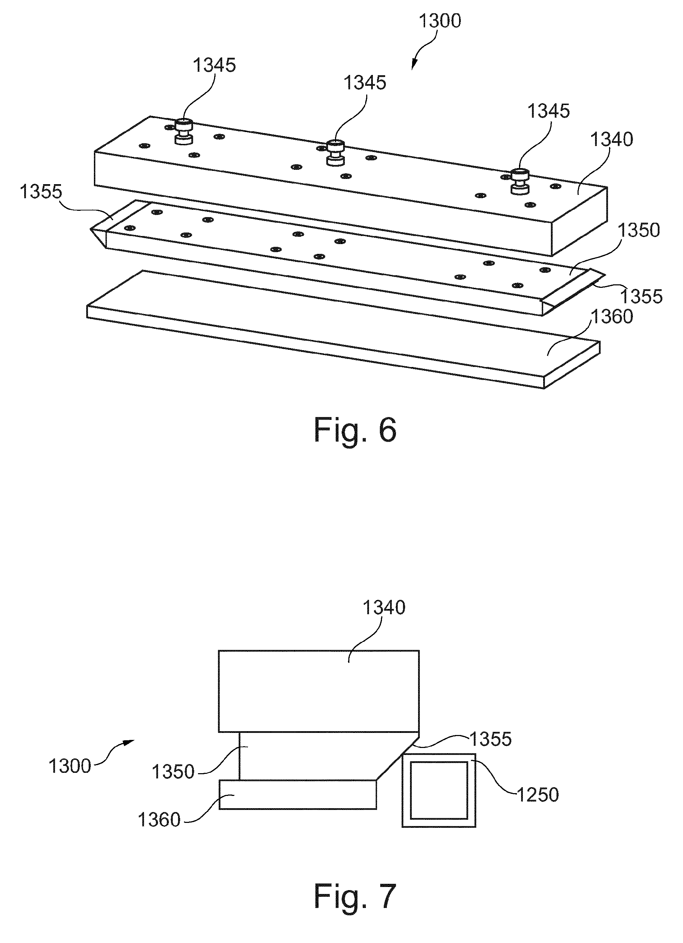

Fig. 6 illustrates a holder 1300, according to embodiments described herein, which may be combined with any other embodiments described herein. The holder 1300 can be reversibly attached to the semiconductor ingot. The holder 1300 can include a top plate 1340, a beam 1350, and a gluing plate 1360. The beam 1350, which is optional, can be disposed between the top plate 1340 and gluing plate 1360. The holder 1300, particularly the top plate 1340 thereof, can include pins and/or pegs 1345 such as for alignment and or gripping with for example a gripper used to move the holder 1300. The holder 1300 can include a self-alignment feature 1355, such as for aligning the holder 1300 to the container, particularly when the holder 1300 rests on a container, such as a container upper surface 1250. Facile and robust alignment is advantageous for enabling rapid loading and unloading of the semiconductor ingot while minimizing the risk of damage to the semiconductor ingot.

For example, the beam 1350 of the holder 1300 can include a self-alignment feature 1355, such as a beveled edge thereof, although a self-alignment feature 1355 disposed on the top plate 1340, beam 1350, and/or gluing plate 1360 is also contemplated. The self-alignment feature, e.g. a beveled edge, can extend around the perimeter of the holder 1300, such as around the perimeter of the beam 1350, gluing plate 1360, or top plate 1340. Alternatively, the self-alignment feature, e.g. a beveled edge, can be located along at least one edge of the holder 1300, such as along opposite edges. A self-alignment feature 1355 which includes a beveled edge along each opposite edge of the holder 1300, such as the edges perpendicular to the long axis of the container, is advantageous, particularly when the loading and unloading is done from the side, e.g. in the direction of the short axis of the carrier.

Fig. 7 illustrates a holder 1300 resting on a container upper surface 1250, according to embodiments described herein, which may be combined with any other embodiments described herein. The holder 1300 can align with a container 120, such as when the holder rests on the container. The holder 1300 and container upper surface 1250 can be dimensioned such that the beveled edge rests on the container upper surface 1250 when the holder 1300 rests on the container 120. As depicted in Fig. 7, the container upper surface 1250 can be a segment of carrier tubing. Alternatively/additionally, the container upper surface 1250 can have a shape complementary to the self-alignment feature 1355, e.g. a beveled edge. The holder 1300 and/or container upper surface 1250 can be castellated such that, for example, the holder 1300 aligns with the container 120 when the holder 1300 rests on the container 120. For example, the self-alignment feature 1355 is castellated. The castellation can be dimensioned so as to align with the container 120 when the holder 1300 rests on an upper surface of the container 120. For example, at least part of the perimeter of the holder 1300 is castellated, and the castellation is dimensioned so as to align with the container 120 when the holder 1300 rests on an upper surface of the container 120. For example, the short edges and long edges of the holder 1300 are castellated. Alternatively/additionally, the long edge of the holder opposite the movable side member is castellated.

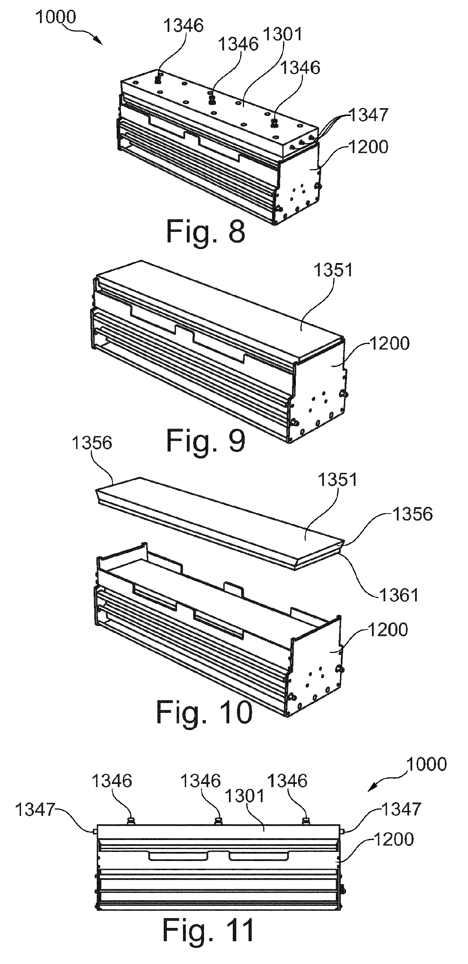

Fig. 8 illustrates a holder 1301 resting on a container 1200, according to embodiments described herein, which may be combined with any other embodiments described herein. The holder 1301 can include a handle attached thereto, for coupling a gripper, for handling the semiconductor ingot via the holder 1301. The holder 1301, particularly the handle thereof, can include pins 1347 and/or pegs 1346. The pins 1347 and/or pegs 1346 can allow the holder 1301 to be gripped by a device external to the carrier, such as for loading and/or unloading of the semiconductor ingot attached to the holder into and/or out of the container 1200. The pins 1347 and/or pegs 1346 can be adapted to allow gripping during side-loading and side-unloading.

Fig. 9 illustrates a holder 1301 minus the top plate thereof, resting on a container 1200, according to embodiments described herein, which may be combined with any other embodiments described herein. Fig. 10 illustrates a holder 1301 minus the top plate thereof, above a container 1200, according to embodiments described herein, which may be combined with any other embodiments described herein. Figs. 9 and 10 depict how a beam 1351 of a holder can include self-alignment features 1356 such as beveled edge(s) which can align with the container 1200. A gluing plate 1361 can be arranged below the beam 1351.

Fig. 11 illustrates a side view of a carrier 1000 including a holder 1301 and a container 1200. For example, a holder 1301 can include pins 1347 along the short edge of the holder, such as along the short edge of the top plate 1341. The pins 1347 can extend parallel to the long axis of the carrier 1000, and can extend farther than the edge of the container 1200. The pins 1347 can be adapted to complement the dimensions of a gripper used for moving the holder, particularly a gripper configured for side loading and unloading. The pins 1347 can be adapted to fit within a transport device which may transport the carrier 1000, for example, within a solar cell manufacturing plant, such as to and/or from a processing apparatus such as a wire saw. Pegs 1346 can extend vertically from the top surface of the holder 1301, such as from the top plate thereof, and can be suitably shaped for lifting of the holder 1301 in a vertical direction by an overhead gripping device (e.g. vertical loading/unloading of the semiconductor ingot). The pegs 1346 can be adapted for top-loading and unloading.

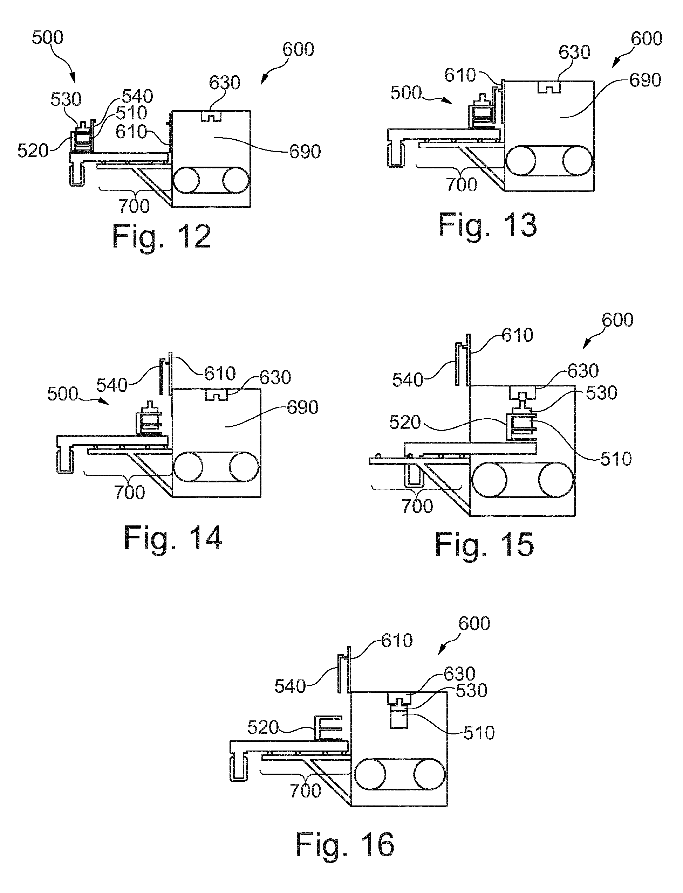

Figs. 12 through 16 illustrate transferring a semiconductor ingot to a processing apparatus, according to embodiments described herein, which may be combined with any other embodiments described herein. The processing apparatus 600, such as a wire saw, can be configured to receive the semiconductor ingot 510 by side-unloading the semiconductor ingot 510 from the carrier 500. The semiconductor ingot 510 can be reversibly attached to the holder 530. The holder 530 may hold the semiconductor ingot 510 during transfer to/from the processing apparatus 600, and optionally during the processing of the semiconductor ingot 510 by the processing apparatus 600. Top-loading and unloading of a semiconductor ingot into/out of the container 520 can be possible, particularly when the container 520 is outside of the processing apparatus 600, such as is depicted in Fig. 12. Side-loading and side-unloading of a semiconductor ingot into/out of the container 520 is particularly advantageous when the container is within the processing apparatus 600, such as a chamber 690 thereof, particularly in chambers with limited overhead clearance.

In Fig. 12 to Fig. 13, a carrier 500 containing a semiconductor ingot 510 is delivered to the processing apparatus 600, according to embodiments described herein, which may be combined with any other embodiments described herein. The carrier 500 may be transported to/from the processing apparatus 600 by a conveying device such as conveyer 700 as depicted in Figs. 12 through 24. The processing apparatus 600 can include an actuator 610 which can move the side member 540 of the carrier 500. The actuator 610 can be external to a processing chamber 690 (such as a cutting chamber) of the processing apparatus 600 (such as a wire saw). For example, the actuator 610 can be integrated with a chamber door of the processing apparatus 600. The delivery of the carrier 500 to the processing apparatus 600 can include, such as terminate with, interfacing, such as coupling and/or reversibly locking the side member 540 of the holder 530 with the actuator 610.

In Fig. 13 to Fig. 14, a carrier containing a semiconductor ingot is opened by an actuator, according to embodiments described herein, which may be combined with any other embodiments described herein. The actuator 610 and/or door of the processing apparatus 600 can be configured such that opening the door to the processing chamber 690 of the processing apparatus 600 moves the side member 540 of the carrier 500 from the closed position to the open position. For example, by opening the side member 540, the side member 540 is lifted above the holder 530, the holder 530 resting on the container 520. This can advantageously provide clearance for subsequent motion of the container 520 and/or semiconductor ingot. The processing apparatus 600 can be a wire saw and the processing chamber 690 can be a cutting chamber.

Opening the side member 540 as the chamber door is opened is advantageous in that the semiconductor ingot 510 can be enclosed while outside of the processing apparatus 600, which protects the semiconductor ingot 510 from the environment, preventing contamination for example. Protection of the semiconductor ingot from the environment is relevant for loading and unloading of the semiconductor ingot, particularly in a cutting environment where kerf and/or cutting fluid aerosol may be present. The side member 540 of the carrier 500 can be opened after the carrier 500 is inserted into the processing chamber 690, particularly in the case of a carrier 500 which includes a rotatable side member 540. A rotatable side member 540 (e.g. Fig. 4) can allow the carrier 500 to be opened within a chamber with a small chamber height.

In Fig. 14 to Fig. 15, a semiconductor ingot is placed in the processing apparatus (such as the chamber thereof), according to embodiments described herein, which may be combined with any other embodiments described herein. For example, the carrier 500 with the side member 540 in the open position can be transferred into the processing apparatus 600, minus the side member 540 of the carrier. The holder 530 of the carrier 500 can be placed in alignment with a gripper 630 of the processing apparatus 600.

In Fig. 15 to Fig. 16, the holder 530 of the carrier 500 is coupled to the gripper 630 of the processing apparatus 600, according to embodiments described herein, which may be combined with any other embodiments described herein. For example, a handle of the holder 530 is coupled to the gripper 630. The container 520 can be removed from the processing apparatus 600. The gripper 630 can be used for handling the semiconductor ingot 510 via the holder 530. The gripper 630 can be for supporting the holder 530 particularly with a semiconductor ingot 510 attached thereto.

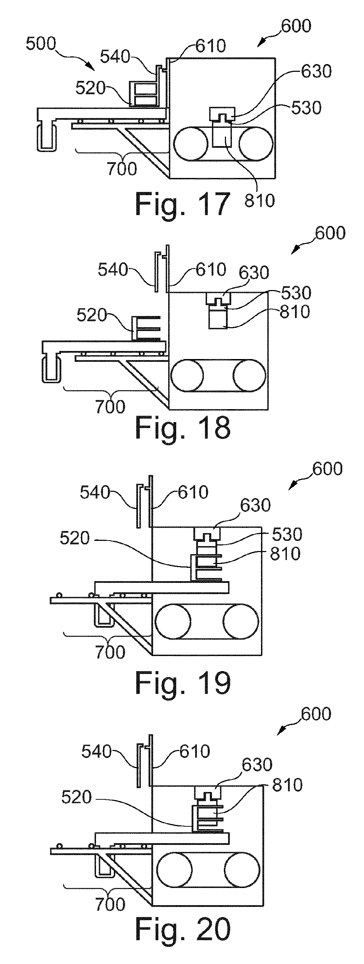

Figs. 17 through 24 illustrate loading a processed semiconductor ingot 810 into a carrier 500, according to embodiments described herein, which may be combined with any other embodiments described herein. The carrier 500 and processing apparatus 600 can be configured for side-loading of the semiconductor ingot into the carrier 500.

Fig. 17 illustrates a processing apparatus 600 containing a processed semiconductor ingot, and a carrier 500, according to embodiments described herein, which may be combined with any other embodiments described herein. A processed semiconductor ingot 810 attached to the holder 530 of a carrier 500 can be situated in a processing apparatus (e.g. a wire saw), such as a chamber thereof.

Figs. 17 and 18 illustrate moving the side member 540 of the carrier 500, according to embodiments described herein, which may be combined with any other embodiments described herein. The side member 540 of the carrier 500 can be moved to the open position before loading the processed semiconductor ingot 810 into the carrier 500. The processed semiconductor ingot 810 can be positioned to enable movement of the container 520 into the processing apparatus 600. The processed semiconductor ingot 810 can be moved vertically, such as by the holder 530 and gripper 630 attached thereto, out of (e.g. above) a horizontal path of the container 520, such as a horizontal path of insertion of the container into the chamber.

Figs. 18 and 19 illustrate loading of a processed semiconductor ingot into the container 520, according to embodiments described herein, which may be combined with any other embodiments described herein. The processed semiconductor ingot 810 can be side-loaded into the container 520, for example by horizontal motion of the container 520. For example, the container 520 is moved horizontally, such as into the chamber 690, and the processed semiconductor ingot 810 can be loaded into the container 520 by side-loading. A conveyer 700 can move the container 520 into the chamber 690.

Figs. 19 and 20 illustrate loading of the processed semiconductor ingot into the container 520, according to embodiments described herein, which may be combined with any other embodiments described herein. The holder 530, which can hold the processed semiconductor ingot 810, can optionally be moved vertically downward by the gripper 630 for final placement of the processed semiconductor ingot 810 in the container 520. Final placement of the processed semiconductor ingot 810 can result in the holder 530 resting on an upper surface of the container 520.

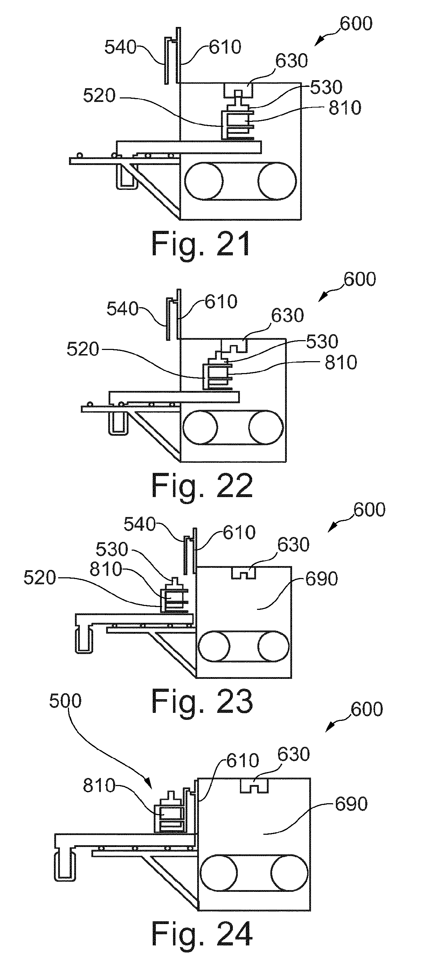

Figs. 20 and 21 illustrate decoupling such as unlocking and/or detachment of the gripper 630 from the holder 530, according to embodiments described herein, which may be combined with any other embodiments described herein. Detachment of the gripper 630 from the holder 530 may be accompanied by vertical lifting of the gripper 630 holder 530, such as to provide clearance between the gripper 630 and holder 530 for subsequent movement of the container 520 which contains the processed semiconductor ingot 810.

Figs. 21 and 22 illustrate movement of the container out of the processing apparatus, according to embodiments described herein, which may be combined with any other embodiments described herein. The container 520 containing the processed semiconductor ingot 810 can be horizontally moved out of the processing apparatus 600, particularly the chamber 690 thereof, such as by the conveyer 700. The gripper 630 can be located so as to provide clearance for the horizontal movement of the container 520.

Figs. 22 and 23 illustrate alignment of the container with the side member, according to embodiments described herein, which may be combined with any other embodiments described herein. The container 520 can be moved, such as by the conveyer 700, so as to align the container 520 which contains the semiconductor ingot 810 with the side member 540.

Figs. 23 and 24 illustrate closing the movable side member, according to embodiments described herein, which may be combined with any other embodiments described herein. The side member 540 can be closed for example by vertically moving the side member 540 down by the actuator 610 of the processing apparatus 600.

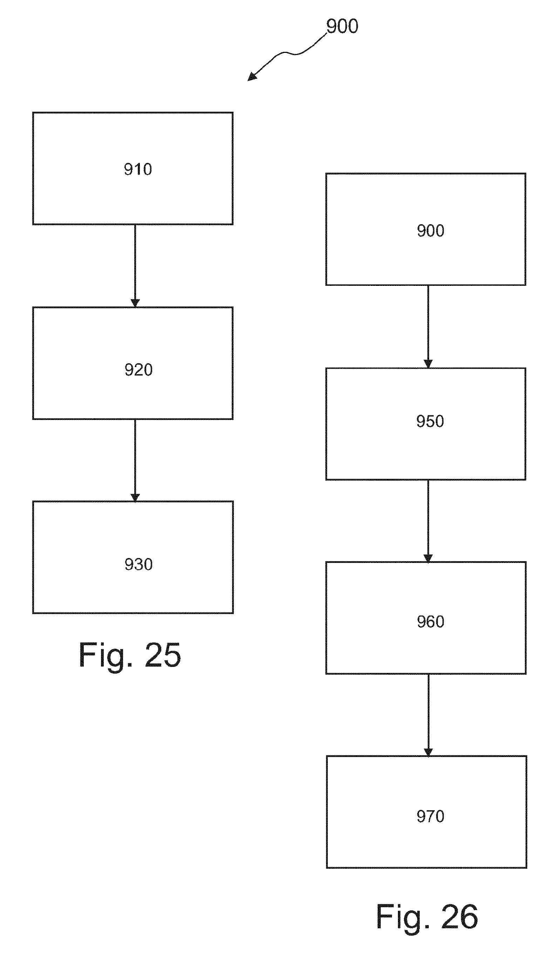

Fig. 25 illustrates schematically a method of transferring a semiconductor ingot to a processing apparatus, according to embodiments described herein, which may be combined with any other embodiments described herein. The semiconductor ingot can be transferred 900 to a processing apparatus by: delivering 910 the carrier, containing a semiconductor ingot, such as a semiconductor ingot attached to a holder, to the processing apparatus; opening 920 the side member of the carrier; and unloading 930 the semiconductor ingot from the side of the carrier (side-unloading). Prior to opening 920 of the side member, the side member can be coupled to an actuator, such as an actuator of the processing apparatus. The opening 920 of the side member can be performed while a door to the processing apparatus is opened; in another embodiment, the opening 920 of the side member can be performed after the carrier is inserted into the processing apparatus, such as a chamber thereof.

Fig. 26 illustrates schematically a method of transferring and processing a semiconductor ingot, according to embodiments described herein, which may be combined with any other embodiments described herein. Following transfer 900 of the semiconductor ingot, the semiconductor ingot can be processed 950 to form a processed semiconductor ingot, the processed semiconductor ingot can be loaded 960 into the carrier by side-loading, and the movable side member of the carrier can be closed 970.

The container and methods of use (e.g. transferring and processing methods) described herein, are particularly well-suited for processes related to slicing of semiconductor ingots with wire saws, such as to make wafers. However, the container and methods of use described herein are also contemplated to be advantageous for other semiconductor ingot processing apparatuses and processes.

While the foregoing is directed to embodiments, other and further embodiments may be devised without departing from the basic scope thereof, and the scope thereof is determined by the claims that follow.

## Claims

1. A carrier (100) for a semiconductor ingot (110), comprising:
a container (120) ; wherein
the container (120) includes a side member (140), the side member (140) being movable between
an open position for side-loading and a closed position.

2. A carrier (100) according to claim 1, further comprising a holder (130); wherein
the container (120) is configured for top-loading and side-loading of a semiconductor ingot (110, 810) attached to the holder (130); wherein optionally the holder (130) rests on the container (120) when the semiconductor ingot (110) is within the container (120); wherein optionally
the holder (130) is adapted for reversible placement at the top of the container (120), and wherein optionally
the bottom of the holder (130) is configured for attachment to the semiconductor ingot (110), such that the container (120) is adapted for containing the semiconductor ingot (110) therein.

3. The carrier (100) of any preceding claim, wherein
the container (120) is configured for top-loading and side-loading of a semiconductor ingot (110, 810).

4. The carrier (100) of claim 2, wherein
the holder (1300) includes a self-alignment feature (1355) for aligning the holder (130) to the container (120) when the holder (130) rests on the container (120), particularly a container upper surface (1250); wherein
the self-alignment feature (1355) is optionally a beveled edge, and
the holder (130) and container upper surface (1250) are optionally dimensioned such that the beveled edge rests on the container upper surface (1250) when the holder (1300) rests on the container (120); wherein optionally the beveled edge extends along opposite edges of the holder (1300), optionally along the perimeter of the holder (130); wherein optionally the container upper surface (1250) has a shape complementary to the self-alignment feature (1355).

5. The carrier (100) of claims 2 or 4, wherein
a handle (1346, 1347) is attached to the holder (130) for coupling a gripper (630) thereto, for handling the semiconductor ingot (110) via the holder (130).

6. The carrier (100) of any preceding claim, wherein
the side member (140) is configured to be moved by an actuator (610), wherein optionally
the actuator (610) is external to the carrier (100).

7. The carrier (100) of any preceding claim, wherein
the side member (140), when in the closed position, is disposed parallel to a long axis of the carrier (100); wherein optionally the side member (140), when in the open position, is disposed parallel to a long axis of the carrier (100).

8. The carrier (100) of any preceding claim, wherein
the side member (140) is rotatable; wherein a rotation of the side member (140) moves the side member (140) between the open position and the closed position; wherein the rotation is optionally along an axis parallel to the long axis of the container (120); wherein the carrier (100) is optionally configured for side-loading and side-unloading of the semiconductor ingot (110) in a direction perpendicular to the long axis of the container (120).

9. The carrier (100) of any preceding claim, wherein
the side member (140) is a side wall of the container (120), such as a side wall which is parallel to the long axis of the container (120).

10. The carrier (100) of any preceding claim, wherein
the side member (140) is movable in a vertical direction, wherein the open position is such that the side member (140) is above the top of the remainder of the container (120), particularly a holder (130) thereof, when the holder (130) is resting on the container (120), and the closed position is such that the side member (140) is disposed on a side of an internal space contained by the container (120), the internal space suitable for containing the semiconductor ingot (110).

11. A processing apparatus (600) for processing a semiconductor ingot (110), wherein the processing apparatus is configured to receive the semiconductor ingot (110), by side-unloading, from the carrier (100) of any preceding claim; wherein the processing apparatus is optionally a wire saw.

12. The processing apparatus (600) of any preceding claim, comprising:
an actuator (610) for moving the side member (540) of the carrier (500) between the closed position and the open position; wherein
the actuator (610) is optionally external to a processing chamber (690) of the processing apparatus (600) ; wherein
the actuator (610) is optionally integrated with a chamber door; wherein optionally
the door is configured such that opening the door moves the side member (540) of the carrier (500) from the closed position to the open position; wherein
the processing chamber (690) is optionally a cutting chamber, particularly a cutting chamber of a wire saw.

13. The processing apparatus (600) of any preceding claim, further comprising a gripper (630) for supporting the holder (130) and semiconductor ingot (110) attached thereto.

14. A method of transferring (900) a semiconductor ingot (110, 510) to a processing apparatus (600),
comprising:
delivering (910) the carrier (100, 500) of any preceding claim to the processing apparatus (600), wherein
the carrier (100, 500) contains a semiconductor ingot (110);
opening (920) the side member (140) of the carrier; and
unloading (930) the semiconductor ingot (110) from the side of the carrier.

15. A method of transferring and processing a semiconductor ingot (110), comprising:
the method of transferring (900) the semiconductor ingot (110) of claim 14;
processing (950) the semiconductor ingot (110) to form a processed semiconductor ingot (810);
loading (960) the processed semiconductor ingot (810) into the carrier by side-loading;
closing (970) the side member (140) of the carrier; wherein optionally processing is slicing, the processing apparatus (600) is a wire saw; and the processed semiconductor ingot (810) is a sliced semiconductor ingot (110).
